# EUROPEAN PATENT APPLICATION

(11) **EP 2 465 971 A2**
(43) Date of publication of application: **20.06.2012**
(21) Application number: 10808364.3
(22) Date of filing: 12.08.2010
(51) Int. Cl.: C23C 16/44, C23C 16/54, H01L 21/205

(54) **APPARATUS FOR FORMING LAYER**

(30) Priority: 13.08.2009 KR 20090074923
(71) Applicant: Kim, Nam Jin, Gyeonggi-do 440-716 (KR)
(72) Inventor: Kim, Nam Jin, Gyeonggi-do 440-716 (KR)
(74) Representative: Zimmermann, Tankred Klaus
(86) International application number: PCT/KR2010/005289
(87) International publication number: WO 2011/019215

(57) **Abstract**

A layer deposition apparatus and method is provided. The layer deposition method comprises a load-lock chamber in which a substrate is loaded, a transfer chamber having a transfer robot that transfers the substrate, a reaction chamber that receives the substrate from the transfer robot and grows at least one epitaxial layer on the substrate, a process-separation reaction chamber that receives the substrate and forms at least one epitaxial layer on the substrate, and a gas distributor that supplies a processing gas to the reaction chamber and the process-separation reaction chamber.

## Description

### CROSS-REFERENCE TO RELATED APPLICATION

This application claims priority to Korean Patent Application No. 10-2009-0074923 filed on August 13, the contents of which are herein incorporated by reference in its entirety.

### BACKGROUND OF THE INVENTION

### 1. Technical Field

Embodiments of the present invention are directed to a layer deposition apparatus, and more specifically to a MOCVD apparatus and method that grows a nitride material

### 2. Discussion of the Related Art

Nitride materials are known as materials for manufacturing light emitting devices (LEDs). An LED employing a nitride material includes a buffer layer formed of GaN on a sapphire substrate, an n-ype layer formed of n-type GaN on the buffer layer, an active layer formed of InGaN on the n-ype layer, and a p-ype layer formed of p-type GaN on the active layer. The layers are sequentially deposited in a metal organic chemical vapor deposition (MOCVD) apparatus.

Due to its utility, Magnesium (Mg) or zinc (Zn) is generally used as a dopant of the p-ype layer. Accordingly, when forming the P-ype layer, Mg or Zn is generated as unwanted materials. GaN or Indium is generated as unwanted materials upon forming the layers deposited prior to the p-typed doped layer. GaN may be easily decomposed or may be recycled during a process without damaging crystal growth. Also, Indium is exhausted to the outside of the chamber by an exhausting function of the MOCVD apparatus in addition to heat without remaining as an unwanted material.

However, dopants, such as Mg or Zn generated when the p-ype layer is formed partially remain as an unwanted material in the MOCVD apparatus.

Such p-type unwanted materials may have a negative effect on an epitaxial process performed on the substrate after completion of an epitaxial process on the LED. For example, when Mg or Zinc infiltrates into the other layers, such as the sapphire substrate, buffer layer, or n-ype layer, during the deposition process, a phenomenon, such as dislocation, may occur at the deposited layers, thus deteriorating emission capability including brightness of the LED.

Accordingly, a process of cleaning the inside of the chamber is performed after multiple epitaxial processes for preparation of another epitaxial process. The frequent cleaning process may lower deposition capability and efficiency of the MOCVD apparatus. As a consequence, it is difficult to lower manufacturing costs of LEDs.

### SUMMARY OF THE INVENTION

Embodiments of the present invention provide a MOCVD apparatus and method, wherein among epitaxial processes for producing LEDs, a P-ype layer deposition process is performed in a chamber independently from the other chambers.

According to an embodiment of the present invention, there is provided a layer deposition apparatus comprising a load-lock chamber in which a substrate is loaded, a transfer chamber having a transfer robot that transfers the substrate, a reaction chamber that receives the substrate from the transfer robot and grows at least on epitaxial layer on the substrate, a process-separation reaction chamber that receives the substrate and forms at least one epitaxial layer on the substrate, and a gas distributor that supplies a processing gas to the reaction chamber and the process-separation reaction chamber.

According to an embodiment, the reaction chamber may epitaxially grow an n-type doped layer and an active layer on the substrate.

According to an embodiment, the process-separation reaction chamber may epitaxially grow a p-type doped layer on the active layer.

According to an embodiment, the layer deposition apparatus may further comprise one or more reaction chamber, each reaction chamber receiving a substrate from the transfer robot and growing at least one epitaxial layer on the substrate, wherein the transfer robot sequentially transfers substrates from the plurality of reaction chambers to the process-separation reaction chamber.

According to an embodiment of the present invention, there is provided a layer deposition method comprising loading a substrate positioned in a load-lock chamber into a transfer chamber by a transfer robot provided in the transfer chamber, transferring the substrate to a reaction chamber, forming at least one epitaxial layer on the substrate in the reaction chamber, transferring the substrate from the reaction chamber to a process-separation reaction chamber by the transfer robot, supplying a second substrate to the reaction chamber and forming at least one epitaxial layer on the second substrate in the reaction chamber, forming at least one epitaxial layer on the substrate in the process-separation reaction chamber, transferring the substrate from the process-separation reaction chamber to the load-lock chamber by the transfer robot, and transferring the second substrate to the process-separation reaction chamber.

According to an embodiment, the reaction chamber may epitaxially grow an n-type doped layer and an active layer on the substrate.

According to an embodiment, the process-separation reaction chamber may epitaxially grow a p-type doped layer on the active layer.

According to an embodiment, one or more reaction chamber may be connected to the transfer chamber, wherein each reaction chamber receives a substrate from the transfer robot and grows at least one epitaxial layer on the substrate, wherein the transfer robot sequentially transfers substrates from the plurality of reaction chambers to the process-separation reaction chamber.

The MOCVD apparatus and method according to the embodiments of the present invention may repeatedly perform the same process in each chamber a few tens of times or more without a maintenance process, such as cleaning of the inside the chambers. The transfer of substrates or susceptors between the chambers is performed by the transfer robot, thus enhancing efficiency of epitaxial processes in high temperature environments. Thus, manufacturing efficiency of LEDs may be increased and manufacturing costs may be saved.

### BRIEF DESCRIPTION OF THE DRAWINGS

The embodiments of the present invention will became more apparent by describing in reference to the following detailed description when considered in conjunction with example embodiments thereof with reference to the accompanying drawings, in which:
Fig. 1 is a view illustrating a MOCVD apparatus according to an embodiment of the present invention;
Fig. 2 is a view illustrating a reaction chamber and a transfer chamber of a MOCVD apparatus according to an embodiment of the present invention;
Fig. 3 is a flowchart illustrating a MOCVD method according to an embodiment of the present invention;
Fig. 4 is a view illustrating a MOCVD apparatus according to an embodiment of the present invention;
Fig. 5 is a flowchart illustrating a MOCVD method according to an embodiment of the present invention;
Fig. 6 is a view illustrating a MOCVD apparatus according to an embodiment of the present invention;
Figs. 7 and 8 are views illustrating operations of the process-separation reaction chamber included in the MOCVD apparatus of Fig. 6.
Fig. 9 is a flowchart illustrating a MOCVD method according to an embodiment of the present invention;
Figs. 10, 11, and 12 are views illustrating operations of a process-separation reaction chamber included in a MOCVD apparatus according to an embodiment of the present invention;
Fig. 13 is a flowchart illustrating a MOCVD method according to an embodiment of the present invention;
Fig. 14 is a view illustrating a MOCVD apparatus according to an embodiment of the present invention;
Fig. 15 is a flowchart illustrating a MOCVD method according to an embodiment of the present invention;
Fig. 16 is a view illustrating a MOCVD apparatus according to an embodiment of the present invention;
Fig. 17 is a flowchart illustrating a MOCVD method according to an embodiment of the present invention; and
Fig. 18 is a flowchart illustrating a MOCVD method according to an embodiment of the present invention.

### DESCRIPTION OF THE EMBODIMENTS

Hereinafter, exemplary embodiments of the present invention will be described with reference to the accompanying drawings, wherein the same reference numerals may be used to denote the same or substantially the same elements throughout the specification and the drawings. Throughout the drawings, the size of elements may be simplified or exaggerated for precise description. The terms 'first', 'second', 'third', and 'fifth' may be used to distinguish one component from another component. For example, a first component may be named as a second component without deviating from the scope of the present invention. Similarly, the second component may be named as the first component.

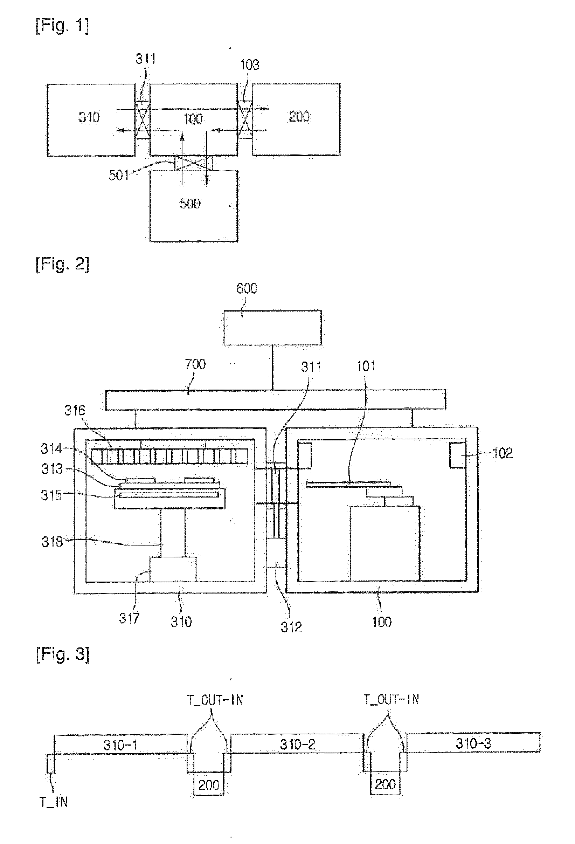

Fig. 1 is a view illustrating a MOCVD apparatus according to an embodiment of the present invention. Fig. 2 is a view illustrating a reaction chamber and a transfer chamber of a MOCVD apparatus according to an embodiment of the present invention.

Referring to Figs. 1 and 2, a MOCVD apparatus, which is an example of a layer deposition layer according to an embodiment of the present invention, includes a load-lock chamber 500 for loading and unloading a substrate or a susceptor, a transfer chamber 100 having a transfer robot 101 for transferring the substrate or the susceptor between chambers, and a plurality chambers 200 and 310 connected to the transfer chamber 100.

The chambers 200 and 310 include a reaction chamber 310 for sequentially depositing a buffer layer, an n-ype layer, an undoped GaN layer, and an active layer on the substrate using group lll-V materials, and a process-separation reaction chamber 200 for independently depositing only a p-ype layer on the active layer.

The MOCVD apparatus further includes a gas supply source 600 for supplying a gas to the transfer chamber 100, the reaction chamber 310, and the process-separation reaction chamber 200, and a gas distributor 700 that distributes the gas from the gas supply source 600 to each of the chambers.

The gas supply source 600 includes a nitrogen gas supply source, a hydrogen gas supply source, a group III gas supply source, a group V gas supply source, an n-type dopant gas supply source, and a p-type dopant gas supply source. The gas supply source 600 includes various gases, each contained in a separate vessel, and a metal organic material, The gas distributor 700 includes gas supply pipes, various control valves, and a flow rate controller. The gas supply source 600 and the gas distributor 700, together, may be referred to as a gas delivery system (GDS).

Among the gases used in the gas supply source, the group III gas supply source may include a trimethylgallium (TMG) gas supply source and a trimethyl-indium (TMI) gas supply source. NH3 may be used as the group V gas supply source, and one of SiH4 and GeH4 may be used as the n-type dopant gas supply source. Iscyclopentadienyl-magnesium (Cp2Mg) may be used as the p-type dopant gas supply source.

According to an embodiment, the first reaction chamber 310 may be a chamber for heat treatment cleaning on the substrate 314 that may be subjected to epitaxial growth, such as GaN, SiC, Si, ZnB2, and GaP substrates, and for growing a GaN buffer layer, an undoped GaN layer, an n-ype layer, and an active layer formed of a single quantum well layer or a multi quantum well layer. Gases, such as nitrogen, hydrogen, a group III gas, a group V gas, and an n-type dopant gas, as required to form the layers, are supplied to the first reaction chamber 310 by the gas distributor 700.

Hydrogen, a group III gas, a group V gas, and a p-type dopant gas are supplied to the process-separation reaction chamber 200 by the gas distributor 700. According to an embodiment, nitrogen or hydrogen, and, if necessary, a group V gas may be supplied to the transfer chamber 100 by the gas distributor 700.

The first reaction chamber 310 will now be described with reference to Fig. 2. The process-separation reaction chamber 200 may be the same or substantially the same as the first reaction chamber 310 in construction.

Referring to Fig. 2, the first reaction chamber 310 includes a shower head 316 that injects a processing gas from an upper portion to a lower portion and a susceptor 313 that is provided under the shower head 316. At least one or more substrate 314 is arranged on the susceptor 313.

A heater 315 is arranged under the susceptor 313 to heat the susceptor 313 to a high temperature. According to an embodiment, the heater 315 may include a tungsten heater, a ceramic heater, or a RF heater. The susceptor 313 may be rotated by a rotating device 317. According to an embodiment, when the susceptor 313 is moved together with the substrate 314, the susceptor 313 may be separated from a rotational shaft 318 of the rotating device 317.

A gate 311 is provided at a side wall of the first reaction chamber 310, which is adjacent to the transfer chamber 100. Through the gate 311, the substrate 314 or the susceptor 313 is loaded in the first reaction chamber 310 or unloaded from the first reaction chamber 310 to the transfer chamber 100. A gate driver 312 is provided to open and close the gate 311.

The transfer chamber 100 includes a transfer robot 101 for transferring the substrate 314 or the susceptor 313. To ensure the stable operation at about 1000°C, the transfer robot 101 may include a heat-resistant material and a heat-insulating structure. According to an embodiment, "Carousel SYSTEMS" commercially available from TEAM Inc. may be employed as the substrate transfer robot that operates at a temperature of 1000 °C or more.

The transfer chamber 100 indudes a heater 102 that heats an inside of the transfer chamber 100 about 600°C to 900°C. According to an embodiment, the heater 120 may include a RF heater that is of an induction heating type, a tungsten heater, or a ceramic heater.

A MOCVD method, which is an example of a layer deposition method according to an embodiment of the present invention, will now be described.

Fig. 3 is flowchart illustrating a MOCVD method according to an embodiment of the present invention.

Referring to Fig. 3, when the substrate 314 or the susceptor 313 on which the substrate 314 is arranged is positioned in the load-lock chamber 500 for an epitaxial process, a gate 501 between the load-lock chamber 500 and the transfer chamber 100 is opened. Then, the transfer robot 101 loads the substrate 314 or the susceptor 313, which has not been treated yet, from the load-lock chamber 500 to an inside of the transfer chamber 100 and closes the gate 501 (T_IN). Meanwhile, gates of the other chambers connected to the transfer chamber 100 remain closed. For example, when a gate connected to the transfer chamber 100 is opened, the other gates connected to the transfer chamber 100 all maintain a closed state.

When the transfer chamber 100 communicates with the load-lock chamber 500, an internal temperature of the transfer chamber 100 may be lower than a required temperature. Accordingly, it may be necessary to heat the transfer chamber 100 after dosing the gate so that the internal temperature of the transfer chamber 100 maintains a predetermined temperature range that ranges from about 600 °C to about 900 °C. According to an embodiment, a temperature range of the load-lock chamber 500 may be maintained to the internal temperature range of the transfer chamber 100. According to an embodiment, a temperature detection device, such as a pyrometer, may be installed in the transfer chamber 100 or the load-lock chamber 500.

Then, when a gate 311 between the first reaction chamber 310 and the transfer chamber 100 is opened, the transfer robot 101 transfers the substrate 314 or the susceptor 313 to the first reaction chamber 310. According to an embodiment, the first reaction chamber 310 may have an internal temperature that has risen to about 1000°C to about 1200°C, or may have a similar temperature range to the internal temperature range of the transfer chamber 100.

When the substrate 314 or the susceptor 313 is loaded from the transfer chamber 100 to the first reaction chamber 310, the transfer robot 101 returns to the transfer chamber 100. Then, the gate 311 is closed.

Thereafter, a first epitaxial process is performed in the first reaction chamber 310 (S310-1). A heat treatment is performed on the substrate 314. For example, the substrate 314 is heated at a temperature of about 1000°C to about 1200°C for two minutes to 20 minutes with an inside of the first reaction chamber 310 in a hydrogen atmosphere. The heat treatment is a pre-bake process for removing unwanted materials, such as an oxide layer, from the substrate 314. A time of heating the substrate 314 in the heat treatment may vary with a diameter of the substrate 314 or the number of substrates 314.

Subsequently, TMG gas and ammonia gas are injected into an inside of the first reaction chamber 310 in the hydrogen atmosphere and a process is performed for about 30 minutes to grow a GaN buffer layer. A temperature of the substrate 314 may reach about 450°C to about 600°C while the buffer layer is formed. The buffer layer may have a thickness of about 20nm.

When the growth of the buffer layer is complete, the inside of the first reaction chamber 310 is heated so that the substrate 314 has a temperature between about 1000°C and about 1100°C, for example, about 1030°C to about 1080°C. Accordingly, an undoped GaN layer is grown on the buffer layer. According to an embodiment, a thickness of the grown undoped GaN layer may reach up to about 3um after about 60minutes. The processes of growing the buffer layer and the undoped GaN layer on the substrate 314 have an effect of enhancing electrical, crystallographic growth efficiency of a GaN thin layer on a sapphire substrate, such as the substrate 314.

Next, an n-ype layer is grown on the undoped GaN layer. An inside of the first reaction chamber 310 has a temperature of about 1000 °C to 1100°C. As processing gases, TMG gas, ammonia, and a doping gas, such as SiH4, are injected into the first reaction chamber 310 in a hydrogen atmosphere. Accordingly, an Si-doped n-type layer is formed, whose thickness reaches up to about 3um for a growth time of about 60 minutes.

Subsequently, an active layer is grown on the n-ype layer. According to an embodiment, the active layer may have a single quantum well (SQW) structure or a multi quantum well (MQW) structure with a plurality of quantum well layers.

To grow the active layer, the inside of the first reaction chamber 310 is changed to have a nitrogen atmosphere and then a temperature of the substrate 314 is variably adjusted between about 700°C and about 900°C (H2) for a time of about 80minutes, thus growing the active layer to a thickness of about 100nm. According to an embodiment, upon forming an MQW structure, quantum barrier layers and quantum well layers that have different contents of indium from each other are alternately formed. The growth may be controlled by a repetitive change in temperature. For growth of the active layer, TMG, TML, and NH3 are supplied to the inside of the first reaction chamber 310 in the nitrogen atmosphere.

When the active layer is completely grown, the gate 311 is opened. The transfer robot 101 returns the substrate 314 or the susceptor 313 to the inside of the transfer chamber 100. When the gate 311 is closed, the substrate 314 or the susceptor 313 is transferred to the process-separation reaction chamber 200 by the transfer robot 101 (T_OUT_IN).

When the gate 103 is opened, the substrate 314 or the susceptor 313 is loaded to an inside of the process-separation reaction chamber 200 by the transfer robot 101. Thereafter, the transfer robot 101 returns to the transfer chamber 100, and the gate 103 is closed. The inside of the process-separation reaction chamber 200 maintains a hydrogen atmosphere.

Hereafter, when the substrate 314 or the susceptor 313 is positioned in the process-separation reaction chamber 200, the process-separation reaction chamber 200 forms a p-ype layer while maintaining the hydrogen atmosphere. A temperature of the substrate 314 may range from about 1000°C to about 1100°C (H3). When the substrate 314 reaches a predetermined temperature, processing gases are supplied to the inside of the process-separation reaction chamber 200. As the processing gases, NH3, TMG, and Cp2Mg are used. When the processing ases are supplied to the process-separation reaction chamber 200 for about 40minutes, a P-ype layer having a thickness of 200nm is formed.

Upon completion of formation of the Pp-ype layer, a temperature of the inside of the process-separation reaction chamber 200, the substrate 314, or the susceptor 313 may be lowered to a temperature (H2) of 600°C to 700°C. According to an embodiment, a processing chamber may be changed to have a nitrogen atmosphere, and subjected to annealing for a predetermined time, thus allowing the Pp-ype layer to have further reduced resistance. Further, the temperature of the inside of the process-separation reaction chamber 200 may be lowered so that the substrate 314 is subjected to passive cooling.

According to an embodiment, annealing and passive cooling may be performed in the transfer chamber 100. For example, after formation of the P-ype layer, the gate 103 is opened so that the transfer robot 101 transfers the substrate 314 or the susceptor 313 to the transfer chamber 100. An inside of the transfer chamber 100 is under a nitrogen atmosphere. The inside of the transfer chamber 100 maintains a temperature of about 600°C to about 900°C, and while the gate 103 is closed, annealing is performed in the transfer chamber 100 for a predetermined time followed by passive cooling. The passive cooling may also be performed in the load-lock chamber 500.

When annealing on the p-ype layer is complete in the process-separation reaction chamber 200 or the transfer chamber 100 and the substrate 314 or the susceptor 313 is positioned in the transfer chamber 100, the gate 501 is opened. The transfer robot 101 transfers the substrate 314 or the susceptor 313 to the load-lock chamber 500. Thereafter, the substrate 314 or the susceptor 313 is transferred for an LED manufacturing process (T_OUT-IN).

The substrate 314 is subjected to an epitaxial process in the process-separation reaction chamber 200, and another substrate is subjected to a deposition process in the first reaction chamber 310 (S310-2). A plurality of substrates or susceptors may be sequentially subjected to predetermined processes in the transfer chamber 100, the first reaction chamber 310, and the process-separation reaction chamber 200 so that an epitaxial process on the plurality of substrates may be swiftly carried out (S200-2 and S310-3).

Mg is generated as a reaction byproduct in the process-separation reaction chamber 200 that independently forms only the P-ype layer. However, Mg does not function as an unwanted material when forming the GaN buffer layer, the undoped GaN layer, or the active layer on the sapphire substrate 314. Other unwanted materials, such as GaN, which are deposited on an inner wall of the first reaction chamber 310, may be previously prevented from being seated on a subsequent substrate by blowing hydrogen or nitrogen gas from the shower head to the substrate before performing epitaxial processes on the substrate.

Accordingly, problems, such as dislocation, caused by Mg or the other unwanted materials during the formation of the P-ype layer, and failure in epitaxial process may be prevented, thus enabling stable crystal growth efficiency.

As a result, the epitaxial process may be repeatedly performed at least 40 to 100 numbers of time in the first reaction chamber 310 and the process-separation reaction chamber 200, and processes may be simultaneously carried out on a plurality of substrates or susceptors in different processing orders, so that the epitaxial process requiring at least 4 to 8 hours may be shortly performed, thus achieving high processing efficiency.

A long processing time is required for a process performed in the first reaction chamber 310. According to an embodiment, a plurality of reaction chambers may be provided to further enhance processing efficiency.

A MOCVD apparatus and method according to an embodiment of the present invention will now be described that employs a plurality of reaction chambers that perform the same process as that of the first reaction chamber 310.

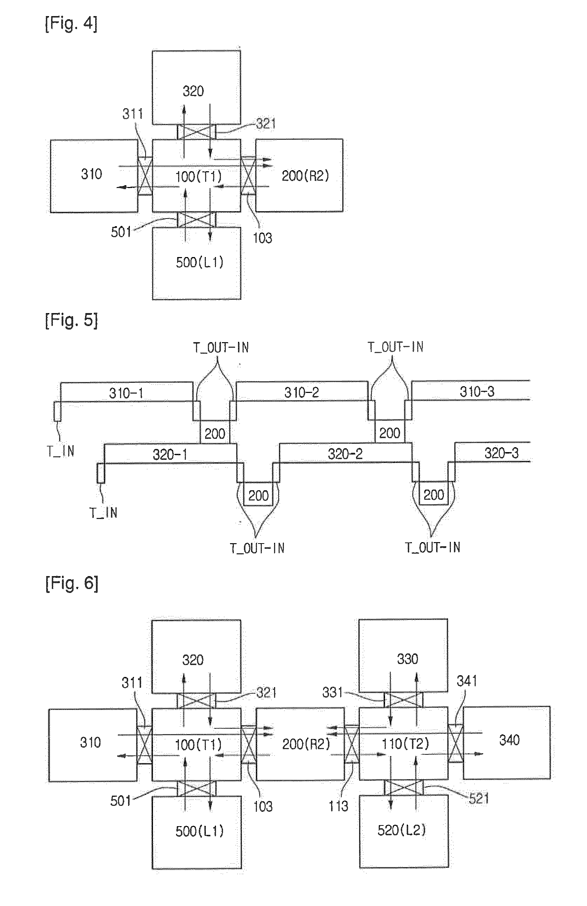

Fig. 4 is a view illustrating a MOCVD apparatus according to an embodiment of the present invention. Fig. 5 is a flowchart illustrating a MOCVD method according to an embodiment of the present invention.

Unlike the embodiment described in connection with Figs. 1 to 3, the MOCVD apparatus according to the present embodiment further includes a second reaction chamber 320 connected to the transfer chamber 100. Like the first reaction chamber 310, the second reaction chamber 320 forms a buffer layer, an undoped GaN layer, an N-ype layer, and an active layer on a substrate.

For example, each of the first reaction chamber 310 and the second reaction chamber 320, respectively, forms a suffer layer, an undoped GaN layer, an N-ype layer, and an active layer on a substrate, The process-separation reaction chamber 200 forms a P-ype layer on the substrates sequentially transferred from the first reaction chamber 310 and the second reaction chamber 320. Two different substrates or susceptors are sequentially transferred to the first reaction chamber 310 and the second reaction chamber 320, and then to the process-separation reaction chamber 200.

This configuration allows the two different substrates or susceptors to be both subjected to processes, thus enhancing processing efficiency as well as durability of each chamber. Since only the second reaction chamber 320 may be performed while the first reaction chamber 310 is subjected to maintenance, maintenance efficiency and processing efficiency are both enhanced, thus increasing operation efficiency of an apparatus.

As shown in Fig. 5, when the substrate 314 (or the susceptor 313 on which at least one or more substrate 314 is arranged) is positioned in the load-lock chamber 500 for an epitaxial process, the transfer robot 101 of the transfer chamber 100 loads the substrate 314 or the susceptor 313 from the load-lock chamber 500 to the transfer chamber 100 (T_IN). After loading of the substrate 314 or the susceptor 313, a gate 501 between the load-lock chamber 500 and the transfer chamber 100 is closed,

Thereafter, when a gate 311 between the transfer chamber 100 and the first reaction chamber 310 is opened, the transfer robot 101 transfers the substrate 314 or the susceptor 313 to the first reaction chamber 310. Then, an epitaxial process is performed on the substrate 314 in the first reaction chamber 310 (310-1). While the substrate 314 is loaded and subjected to the epitaxial process in the first reaction chamber 310, the transfer robot 101 transfers a second substrate (not shown) or susceptor (not shown) from the load-lock chamber 500 to the transfer chamber 100 (T_IN).

When a gate 321 positioned at the second reaction chamber 320 is opened, the transfer robot 101 transfers the second substrate or susceptor to the second reaction chamber 320 and then returns to the transfer chamber 100, and the gate 321 is closed. Thereafter, an epitaxial process is performed on the second substrate in the second reaction chamber 320 (320-1).

While the second substrate is subjected to the epitaxial process in the second reaction chamber 320, the first substrate 314 finishes the epitaxial process in the first reaction chamber 310. The first substrate 314 having experienced the epitaxial process has up to an active layer grown thereon. Then, the first substrate 314 or susceptors 313 is transferred to the process-separation reaction chamber 200 by the transfer robot 101 (T_OUT-IN). A p-ype layer is formed on the first substrate in the process-separation reaction chamber 200. After formation of the p-ype layer on the substrate 314, the first substrate 314 is transferred by the transfer robot 101 to the load-lock chamber 500 via the transfer chamber 100 (T_OUT-IN).

According to an embodiment, after the first substrate 314 has been transferred to the process-separation reaction chamber 200, a third substrate may be loaded into the first reaction chamber 310 for a process (T_OUT-IN), and after the process on the second substrate is complete, a fourth substrate may be loaded into the second reaction chamber 320 for a process (T_OUT-IN). The third substrate may be subjected to an epitaxial process in the first reaction chamber 310 (310-3). Second land third epitaxial processes (320-2 and 320-3) are performed in the second reaction chamber 320. In the process-separation reaction chamber 200, p-type doped-layer formation processes (200-2, 200-3, and 200-4) are sequentially carried out whenever each and every epitaxial process is finished. These processes continue to be done until a maintenance process is performed on the process-separation reaction chamber 200.

According to an embodiment, a temperature at insides of the first reaction chamber 310 and the second reaction chamber 320 may be increased to about 1000°C to about 1200°C. before or after the substrates are loaded therein. The buffer layer, the undoped GaN layer, the N-ype layer, and the active layer are sequentially formed in the first reaction chamber 310 and the second reaction chamber 320 while a hydrogen atmosphere is maintained in the insides of the first reaction chamber 310 and the second reaction chamber 320. The growth process of each of the layers may be performed similarly to the process described in connection with Figs. 1 to 3.

The process-separation reaction chamber 200 forms a p-ype layer while always maintaining a hydrogen atmosphere therein. The p-ype layer may be formed by the same manner as that described in connection with Figs. 1 to 3. According to an embodiment, an annealing process may be performed in the process-separation reaction chamber 200.

Mg is generated as a reaction product in the process-separation reaction chamber 200 when only a pP-ype layer is independently formed in the process-separation reaction chamber 200. However, Mg does not operate as an unwanted material when the buffer layer, the undoped GaN layer, or the active layer is formed on the sapphire substrate 314. Accordingly, problems, such as dislocation, caused by Mg or the other unwanted materials, and failure in epitaxial process may be prevented, thus enabling a high-performance, automated epitaxial process for an LED.

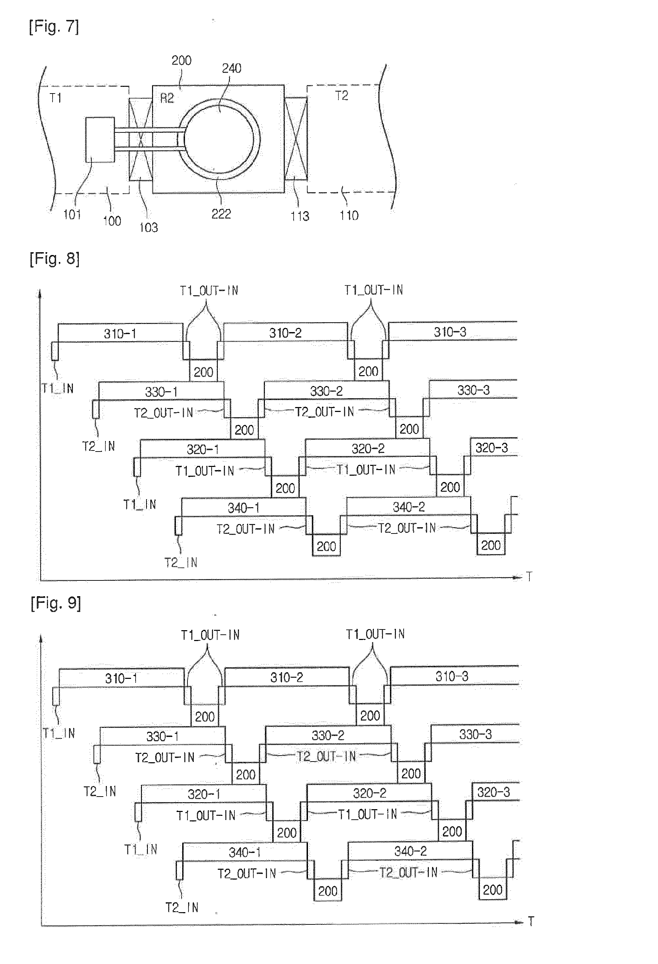

Fig. 6 is a view illustrating a MOCVD apparatus according to an embodiment of the present invention. Figs. 7 and 8 are plan views illustrating using a process-separation reaction chamber included in the MOCVD apparatus of Fig. 6. Fig. 9 is a flowchart illustrating a MOCVD method according to an embodiment of the present invention.

Referring to Fig. 6, the MOCVD apparatus includes two transfer chambers 100(T1) and 110(T2) that are located at left and right sides and load-lock chambers 500(L1) and 520(L2) that are connected to the transfer chambers 100(T1) and 110(T2), respectively, and supply a substrate 240 or a susceptor 222 on which a plurality of substrates 222 are arranged to the transfer chambers 100(T1) and 110(T2), respectively. For sequentially depositing a buffer layer, an undoped GaN layer, an N-ype layer, and an active layer on a substrate, first and second reaction chambers 310 and 320 are connected to the first transfer chamber 100, and third and fourth reaction chambers 330 and 340 are connected to the second transfer chamber 110.

A process-separation reaction chamber 200(R2) is provided between the first transfer chamber 100 and the second transfer chamber 110 to be commonly used for forming a P-ype layer on the substrate 240 that has experienced deposition processes in the first reaction chamber 310 to the fourth reaction chamber 340.

A first load-lock-sided gate 501 is provided between the first load-lock chamber 500 and the frist transfer chamber 100, and a second load-lock-sided gate 521 is provided between the second loard-lock chamber 520 and the second transfer chamber 110.

A first reaction chamber-sided gate 311 is provided between the first transfer chamber 100 and the first reaction chamber 310, and a second reaction chamber-sided gate 321 is provided between the first transfer chamber 100 and the second reaction chamber 320. A third reaction chamber-sided gate 331 is provided between the second transfer chamber 110 and the third reaction chamber 330, and a fourth reaction chamber-sided gate 341 is provided between the second transfer chamber 110 and the fourth reaction chamber 340.

A first transfer chamber-sided gate 103 is provided between the first transfer chamber 100 and the process-separation reaction chamber 200, and a second transfer chamber-sided gate 113 is provided between the second transfer chamber 110 and the process-separation reaction chamber 200.

A substrate 240 positioned in the first load-lock chamber 500 is transferred to the first reaction chamber 310 and the second reaction chamber 320 by a transfer robot provided in the first transfer chamber 100 for processes. When the processes are complete in the first reaction chamber 310 and the second reaction chamber 320, the substrate 240 or a susceptor 222 on which the substrate 240 is arranged is transferred by the transfer robot to the process-separation reaction chamber 200 for a process. A substrate 240 or a susceptor 222 on which the substrate 240 is arranged is transferred to the third reaction chamber 330 and the fourth reaction chamber 340 by a transfer robot provided in the second transfer chamber 110 for processes. When the processes are complete in the third and fourth reaction chambers 330 and 340, the substrate 240 is transferred to the process-separation reaction chamber 200 by the transfer robot for a process.

Figs. 7 and 8 illustrate that processes are sequentially performed in the first to fourth reaction chambers 310, 320, 330, and 340 with a predetermined time difference between two neighboring processes. For example, Fig. 7 illustrates an example where the substrate 240 or the susceptor 222 is transferred from the first transfer chamber 100 to the process-separation reaction chamber 200, and Fig. 8 illustrates an example where the substrate 240 or the susceptor 222 is transferred from the second transfer chamber 110 to the process-separation reaction chamber 200.

For example, when a process is first performed in the first reaction chamber 310 and then processes are sequentially performed in the third reaction chamber 330, the second reaction chamber 320, and the fourth reaction chamber 340, the process on the substrate 240 positioned in the first reaction chamber 310 is first complete. Accordingly, the substrate 240 or the susceptor 222 is transferred by the transfer robot 101 of the first transfer chamber 100 from the first reaction chamber 310 to the process-separation reaction chamber 200 for a process.

When a deposition process is complete in the process-separation reaction chamber 200, the substrate 240 or the susceptors 222 is transferred by the transfer robot 101 of the first transfer chamber 100 from the process-separation reaction chamber 200 to the first load-lock chamber 500 so that the substrate 240 may be discharged to an outside.

When the substrate 240 positioned in the third reaction chamber 330 completes a process, the substrate 240 or the susceptor 222 is transferred to the process-separation reaction chamber 200 by the transfer robot 111 of the second transfer chamber 110 for a process. When the process is complete in the process-separation reaction chamber 200, the substrate 240 or the susceptor 222 is transferred to the second load-lock chamber 520 by the transfer robot 111 of the second transfer chamber 110 so that the substrate 240 may be discharged to an outside.

When the process is complete in the second reaction chamber 320, the substrate 240 or the susceptor 222 is transferred from the second reaction chamber 320 to the process-separation reaction chamber 200 for a process, and thereafter, discharged to an outside via the first load-lock chamber 500. When the process is complete in the fourth reaction chamber 340, the substrate 240 or the susceptor 222 is transferred from the fourth reaction chamber 340 to the process-separation reaction chamber 200 for a process, and thereafter, discharged to an outside via the second load-lock chamber 520.

The processes in the first to fourth reaction chambers 310 to 340 and the process in the process-separation reaction chamber 200 are sequentially performed in the above-described manner.

A MOCVD method according to an embodiment of the present invention will now be described.

As shown in Fig. 9, when a substrate 240 or a susceptor 222 on which a plurality of substrates 240 are arranged are positioned in the first load-lock chamber 500, the first load-lock-sided gate 501 is opened so that the first load-lock chamber 500 may communicate with the first transfer chamber 100.

Under this situation, the substrate 240 is transferred from the first load-lock chamber 500 to the first transfer chamber 100 by the transfer robot of the first transfer chamber 100 and the first load-lock-sided gate 501 is closed (T1-IN). Whereafter, the first reaction chamber-sided gate 311 is opened and the transfer robot transfers the substrate 240 to the first reaction chamber 310. Then, the first reaction chamber-sided gate 311 is closed, and when processing conditions are satisfied, a deposition process is initiated (310-1).

When a substrate 240 or a susceptor 222 on which a plurality of substrates 240 are arranged is positioned in the second load-lock chamber 520, the second load-lock-sided gate 521 is opened so that the second load-lock chamber 520 may communicate with the second transfer chamber 110. Under this circumstance, the substrate 240 is transferred to the second transfer chamber 110 by the transfer robot 111 of the second transfer chamber 110, and then, the second load-lock-sided gate 521 is closed (T2-IN).

Thereafter, the third reaction chamber-sided gate 331 is opened and the transfer robot 111 transfers the substrate 240 to the third reaction chamber 330. Then, the third reaction chamber-sided gate 331 is closed, and when processing conditions are satisfied, a deposition process is initiated (330-1).

When a substrate 240 or a susceptor 222 on which a plurality of substrates 240 is arranged is positioned in the first load-lock chamber 500, the first load-lock-sided gate 501 is opened so that the first load-lock chamber 500 may communicate with the first transfer chamber 100. Under this circumstance, the substrate 240 is transferred by the transfer robot 101 of the first transfer chamber 100 to the first transfer chamber 100, and then, the first load-lock-sided gate 501 is closed (T1-IN).

Hereafter, the second reaction chamber-sided gate 321 is opened, and the substrate 240 is transferred to the second reaction chamber 320 by the transfer robot 101. Then, the transfer robot 101 returns to the first transfer chamber 100 and the second reaction chamber-sided gate 321 is closed. When processing conditions are satisfied, a deposition process is initiated (320-1).

When a substrate 240 or a susceptor 222 on which a plurality of substrates 240 is arranged is positioned in the second load-lock chamber 520, the second load-lock-sided gate 521 is opened so that the second load-lock chamber 520 may communicate with the second transfer chamber 110. Under this circumstance, the substrate 240 is transferred by the transfer robot 111 of the second transfer chamber 110 to the second transfer chamber 110, and then, the second load-lock-sided gate 521 is closed (T2-IN),

Thereafter, the fourth reaction chamber-sided gate 341 is opened, and the substrate 240 is transferred to the fourth reaction chamber 340 by the transfer robot 111. Then, the transfer robot 111 returns to the second transfer chamber 110 and the fourth reaction chamber-sided gate 341 is closed. When processing conditions are satisfied, a deposition process is initiated (340-1).

A predetermined time after the substrate 240 has been transferred from the first transfer chamber 100 to the second reaction chamber 320, the deposition process on the substrate 240 positioned in the first reaction chamber 310 is complete.

When the deposition process is complete in the first reaction chamber 310, the first reaction chamber-sided gate 311 is opened and the transfer robot 101 of the first transfer chamber 100 transfers the substrate 240 to the first transfer chamber 100. Then, the first reaction chamber-sided gate 311 is closed (T1OUT-IN). Under this circumstance, the first transfer chamber-sided gate 103 is opened so that the first transfer chamber 100 may communicate with the process-separation reaction chamber 200. Then, the transfer robot 101 transfers the substrate 240 from the first transfer chamber 100 to the process-separation reaction chamber 200 and then returns to the first transfer chamber 100. Then, the first transfer chamber-sided gate 103 is closed (T1 OUT-IN). Thereafter, a deposition process is performed in the process-separation reaction chamber 200.

When the process is complete in the process-separation reaction chamber 200, the first transfer chamber-sided gate 103 is opened and the transfer robot 101 transfers the substrate 240 to the first transfer chamber 100 (T1OUT-IN). Then, the first load-lock-sided gate 501 is opened and then the transfer robot 101 transfers the substrate 240 to the first load-lock chamber 500. Then, the transfer robot 101 returns to the first transfer chamber 100 and then the first load-lock-sided gate 501 is closed. The deposited substrate 240 is discharged to an outside, and another substrate 240 is positioned in the first load-lock chamber 500 and then subjected to subsequent processes 310-2, 3, ..., and n in the first reaction chamber 310.

The deposition on the substrate 240 positioned in the third reaction chamber 330 is complete. Then, the third reaction chamber-sided gate 331 is opened and the transfer robot 111 of the second transfer chamber 110 transfers the substrate 240 to the second transfer chamber 110. Then, the third reaction chamber-sided gate 331 is close (T2OUT-IN). Under this circumstance, the second transfer chamber-sided gate 113 is opened so that the second transfer chamber 110 may communicate with the process-separation reaction chamber 200. The transfer robot 111 transfers the substrate 240 to the process-separation reaction chamber 200 and then returns to the second transfer chamber 110. Then, the second transfer chamber-sided gate 113 is close (T2OUT-IN). Thereafter, a deposition process is performed in the process-separation reaction chamber 200.

When the process is complete in the process-separation reaction chamber 200, the second transfer chamber-sided gate 113 is opened and the transfer robot 111 transfers the substrate 240 to the second transfer chamber 110 (T2OUT-IN). Then, the second load-lock-sided gate 521 is opened, and the transfer robot 111 transfers the substrate 240 to the second load-lock chamber 520. Then, the transfer robot 111 returns to the second transfer chamber 110, and the second load-lock-sided gate 521 is closed. The deposited substrate 240 is discharged to an outside, and another substrate 240 is positioned in the second load-lock chamber 520, so that subsequent processes 330-2, 3... n are performed in the third reaction chamber 330. Also in the second reaction chamber 320 and the fourth reaction chamber 340 are subsequently performed processes in the above-described sequences 320-2, 3, ..., and n/340-2, 3, ..., and n.

According to an embodiment, P-ype layers may be formed on a first substrate (or first susceptor) transferred from the first transfer chamber 100 and a second substrate (or second susceptor) transferred from the second transfer chamber 110 to the process-separation reaction chamber 200. According to an embodiment, processes in the first reaction chamber 310 and the second reaction chamber 320 may be performed in the same processing times as those for processes in the third reaction chamber 330 and the fourth reaction chamber 340, respectively, thus further enhancing processing efficiency. According to an embodiment, a separate buffer chamber (not shown) may be provided so that among the substrates 240 or susceptors 222 transferred from the first transfer chamber 100 and the second transfer chamber 110 to the process-separation reaction chamber 200, a substrate or a susceptor whose process was first finished may be temporarily stored.

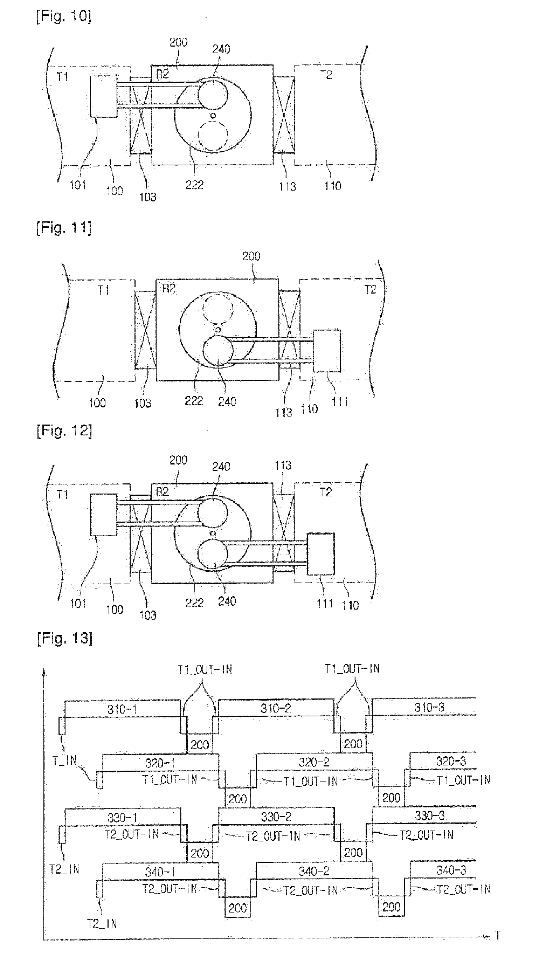

As shown in Figs. 10, 11, and 12, when processes are simultaneously performed in the first reaction chamber 310 and the third reaction chamber 330, the processes are complete at the same time. Then, the first substrate (or first susceptor) and the second substrate (or second susceptor), respectively, are substantially simultaneously transferred from the first reaction chamber 310 and the third reaction chamber 330 to the process-separation reaction chamber 200 via the first transfer chamber 100 and the second transfer chamber 110.

Thereafter, when a process is complete in the process-separation reaction chamber 200, the first substrate (or susceptor) is discharged from the process-separation reaction chamber 200 via the first transfer chamber 100 and the first load-lock chamber 500 to an outside, and the second substrate (or susceptor) is discharged from the process-separation reaction chamber 200 via the second transfer chamber 110 and the second load-lock chamber 520 to an outside.

According to an embodiment, the susceptor 222 positioned in the process-separation reaction chamber 200 may be produced so that an upper portion is symmetrical to a lower portion with respect to a rotational axis.

Fig. 13 illustrates an example where processes are simultaneously performed in the first reaction chamber 310 and the third reaction chamber 330, and in the second reaction chamber 320 and the fourth reaction chamber 340.

When a first substrate (or a first susceptor on which a plurality of substrates are arranged) is positioned in the first load-lock chamber 500 and a second substrate (or a seocnd susceptor on which a plurality of substrates are arranged) is positioned in the second load-lock chamber 520, the first load-lock-sided gate 501 is opened so that the first transfer chamber 100 may communicate with the first load-lock chamber 500, and the second load-lock-sided gate 521 is opened so that the second transfer chamber 110 may communicate with the second load-lock chamber 520.

Under this circumstance, the transfer robot 101 of the first transfer chamber 100 and the transfer robot 111 of the second transfer chamber 110, respectively, transfer the first substrate and the second substrate to the first transfer chamber 100 and the second transfer chamber 110, and then, the first load-lock-sided gate 501 and the second load-lock-sided gate 521 are closed (T1-IN) and (T2-IN). Thereafter, the first reaction chamber-sided gate 311 and the third reaction chamber-sided gate 331 are opened, and the transfer robot 101 and the transfer robot 111, respectively, transfer the first substrate and the second substrate to the first reaction chamber 310 and the third reaction chamber 330 and then return to the first transfer chamber 100 and the second transfer chamber 110. Then, the first reaction chamber-sided gate 31 and the third reaction chamber-sided gate 331 are closed. When processing conditions are satisfied, deposition processes are initiaged at the same time in the first reaction chamber 310 and the third reaction chamber 330 310-1 and 330-1.

A predetermined time after the processes have been performed in the first reaction chamber 310 and the third reaction chamber 330, deposition processes are initiated in the second reaction chamber 320 and the fourth reaction chamber 340. As described above, when a third substrate (or a third susceptor on which a plurality of substrates are arranged) and a fourth substrate (or a fourth susceptor on which a plurality of substrates), respectively, are positioned in the first load-lock chamber 500 and the second load-lock chamber 520, the first load-lock-sided gate 501 and the second load-lock-sided gate 521 are opened so that the first transfer chamber 100 may communicate with the first load-lock chamber 500 and the second transfer chamber 110 may communicate with the second load-lock chamber 520.

Under this circumstance, the transfer robot 101 of the first transfer chamber 100 and the transfer robot 111 of the second transfer chamber 110, respectively, transfer the third and fourth substrates to the first transfer chamber 100 and the second transfer chamber 110, and the first load-lock-sided gate 501 and the second load-lock-sided gate 521 are closed (T1-IN) and (T2-IN). Thereafter, the second reaction chamber-sided gate 321 and the fourth reaction chamber-sided gate 341 are opened, and the transfer robot 101 and the transfer robot 111, respectively, transfer the third and fourth substrates to the second reaction chamber 320 and the fourth reaction chamber 340. Then, the transfer robot 101 and the transfer robot 111 return to the first transfer chamber 100 and the second transfer chamber 110, and then the second reaction chamber-sided gate 321 and the fourth reaction chamber-sided gate 341 are closed, When processing conditions are satisfied, deposition processes are initiated 320-1 and 340-1.

The deposition processes earlier initiated are complete in the first reaction chamber 310 and the third reaction chamber 330. Then, the first reaction chamber-sided gate 311 and the third reaction chamber-sided gate 331 are opened, and the transfer robot 101 of the first transfer chamber 100 and the transfer robot 111 of the second transfer chamber 110, respectively, transfer the first and second substrates to the first transfer chamber 100 and the second transfer chamber 110, then the first reaction chamber-sided gate 311 and the third reaction chamber-sided gate 331 are closed (T1OUT-IN) and (T2OUT-IN). Under this circumstance, the first transfer chamber-sided gate 103 and the second transfer chamber-sided gate 113 are opened so that the first transfer chamber 100 and the second transfer chamber 110 may communicate with the process-separation reaction chamber 200. Then, as shown in Fig. 13, the transfer robot 101 and the transfer robot 111, respectively, transfer the first and second substrates to the process-separation reaction chamber 200 and then return to the first transfer chamber 100 and the second transfer chamber 110. Theater, the first transfer chamber-sided gate 103 and the second transfer chamber-sided gate 113 are closed (T1OUT-IN) and (T2OUT-IN). Then, a deposition process is performed in the process-separation reaction chamber 200.

When the process is complete in the process-separation reaction chamber 200, the first transfer chamber-sided gate 103 and the second transfer chamber-sided gate 113 are opened, and the transfer robot 101 and the transfer robot 111, respectively, transfer the first and second substrates to the first transfer chamber 100 and the second transfer chamber 110 (T1OUT-IN) and (T2OUT-IN). Then, the first load-lock-sided gate 501 and the second load-lock-sided gate 521 are opened, and the transfer robot 101 and the transfer robot 111, respectively, transfer the first and second substrates to the first load-lock chamber 500 and the second load-lock chamber 520, then return to the first transfer chamber 100 and the second transfer chamber 110. Then, the first load-lock-sided gate 501 and the second load-lock-sided gate 521 are closed, The deposited first and second substrates are discharged to an outsde, and other substrates are positioned in the first load-lock chamber 500 and the second load-lock chamber 520, respectively, for subsequent processes in the first reaction chamber 310 and the third reaction chamber 330 (310-2, 3, ..., and n) and (330-2, 3, ..., and n).

The second reaction chamber 320 and the fourth reaction chamber 340 are subjected to processes in the same way as described above (320-2, 3, ..., and n) and (340-2, 3, ..., and n).

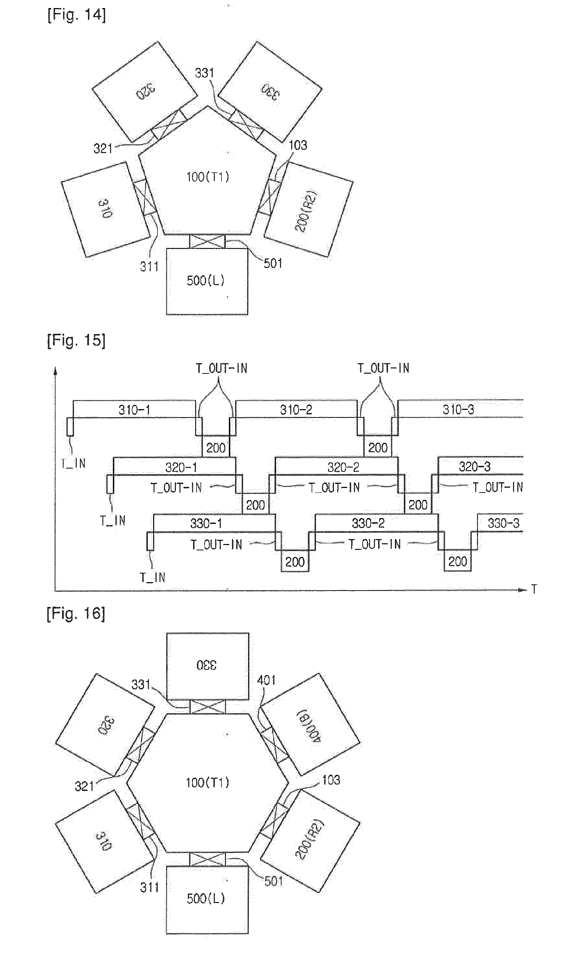

Fig. 14 is a view illustrating a MOCVD apparatus according to an embodiment of the present invention. Fig. 15 is a flowchart illustrating a MOCVD method according to an embodiment of the present invention.

Referring to Fig. 14, the MOCVD apparatus includes a trans chamber 100(T1) which has a pentagonal shape, three reaction chambers 310, 320, and 330, a load-lock chamber 500(L), and a process-separation reaction chamber 200(R2). The first reaction chamber 310, the second reaction chamber 320, and the third reaction chamber 330 form a bluffer layer, an undoped GaN layer, an N-ype layer, and an active layer. The process-separation reaction chamber 200 forms a P-ype layer.

A load-lock-sided gate 501 is provided between the load-lock chamber 500 and the transfer chamber 100.

A first reaction chamber-sided gate 311, a second reaction chamber-sided gate 321, and a third reaction chamber-sided gate 331, respectively, are provided between the transfer chamber 100 and the first reaction chamber 310, between the transfer chamber 100 and the second reaction chamber 320, and between the transfer chamber 100 and the third reaction chamber 330.

A transfer chamber-sided gate 103 is provided between the process-separation reaction chamber 200 and the transfer chamber 100.

Substrates 240 positioned in the load-lock chamber 500 are transferred to the first reaction chamber 310 to the third reaction chamber 330 by a transfer robot 101 provided in the transfer chamber 100, followed by being subjected to processes. When the processes are complete in the first reaction chamber 310 to the third reaction chamber 330, the substrates are transferred by the transfer robot 101 to the process-separation reaction chamber 200 for a process.

A MOCVD method according to an embodiment of the present invention will now be described, which includes procecces performed in the chambers.

Fig. 15 illustrates an example of sequentially performing processes in the first reaction chamber 310 to the third reaction chamber 330, wherein X axis refers to processing time and Y axis refers to transfer of the substrate 240 into each of the chambers. The processing conditions performed in the load-lock chamber 500, the transfer chamber 100, and the reaction chambers 310, 320, and 330 and gases supplied into the chambers have been described above.

When a first substrate or a first susceptor on which a plurality of substrates are arranged is positioned in the load-lock chamber 500, the first load-lock-sided gate 501 is opened so that the transfer chamber 100 may communicate with the load-lock chamber 500. Under this circumstance, a transfer robot 101 of the transfer chamber 100 transfers the first substrate to the transfer chamber 100, and the first load-lock-sided gate 501 is closed (T-IN). Hereafter, the first reaction chamber-sided gate 311 is opened, and the transfer robot 101 transfers the first substrate to the first reaction chamber 310, then returns to the transfer chamber 100. Then, the first .reaction chamber-sided gate 311 is closed. When processing conditions are satisfied, a deposition process is initiated (310-1).

When a second substrate or a second susceptor on which a plurality of substrates are arranged is positioned in the load-lock chamber 500, the first load-lock-sided gate 501 is opened so that the transfer chamber 100 may communicate with the load-lock chamber 500. Under this circumstance, the transfer robot 101 transfers the second substrate to the transfer chamber 100, and the first load-lock-sided gate 501 is closed (T-IN).

Thereafter, the second reaction chamber-sided gate 321 is opened, and the transfer robot 101 transfers the second substrate to the second reaction chamber 320, then returns to the transfer chamber 100. Then, the second reaction chamber-sided gate 321 is closed. When processing conditions are satisfied, a deposition process is initiated (320-1).

When a third substrate or a third susceptor on which a plurality of substrates are arranged is positioned in the load-lock chamber 500, the first load-lock-sided gate 501 is opened so that the transfer chamber 100 may communicate with the load-lock chamber 500. Under this circumstance, the transfer robot 101 transfers the third substrate to the transfer chamber 100, and the first load-lock-sided gate 501 is closed (T-IN).

Thereafter, the third reaction chamber-sided gate 331 is opened, and the transfer robot 101 transfers the third substrate to the third reaction chamber 330, then returns to the transfer chamber 100. Then, the third reaction chamber-sided gate 331 is closed. When processing conditions are satisfied, a deposition process is initiated (330-1).

A predetermined time after the third substrate has been transferred to the third reaction chamber 330, the deposition process on the first substrate in the first reaction chamber 310 is complete. Then, the first reaction chamber-sided gate 311 is opened, and the transfer robot 101 transfers the first substrate to the transfer chamber 100, then the first reaction chamber-sided gate 311 is closed (TOUT-IN). Under this circumstance, the transfer chamber-sided gate 103 is opened so that the transfer chamber 100 may communicate with the process-separation reaction chamber 200. Then, the transfer robot 101 transfers the first substrate to the process-separation reaction chamber 200, and then returns to the transfer chamber 100, then the transfer chamber-sided gate 103 is closed (TOUT-IN). Thereafter, a deposition process is initiated in the process-separation reaction chamber 200.

When the process is complete in the process-separation reaction chamber 200, the transfer chamber-sided gate 103 is opened, and the transfer robot 101 transfers the first substrate to the transfer chamber 100 (TOUT-IN). Then, the first load-lock-sided gate 501 is opened, and the transfer robot 101 transfers the first substrate to the load-lock chamber 500, then returns to the transfer chamber 100. Thereafter, the first load-lock-sided gate 501 is closed. The first substrate thusly deposited is discharged to an outside, and subsequent processes (310-2, 3, ..., and n) are performed on another substrate in the first reaction chamber 310.

And, the deposition process on the second substrate in the second reaction chamber 320 is complete. Then, the second reaction chamber-sided gate 321 is opened, and the transfer robot 101 transfers the second substrate to the transfer chamber 100, then the second reaction chamber-sided gate 321 is closed (TOUT-IN). Under this circumstance, the transfer chamber-sided gate 103 is opened so that the transfer chamber 100 may communicate with the process-separation reaction chamber 200. Then, the transfer robot 101 transfers the second substrate to the process-separation reaction chamber 200 and then returns to the transfer chamber 100 and the transfer chamber-sided gate 103 is closed (TOUT-IN). Hereafter, a deposition process is performed in the process-separation reaction chamber 200.

When the process is complete in the process-separation reaction chamber 200, the transfer chamber-sided gate 103 is opened, and the transfer robot 101 transfers the second substrate to the transfer chamber 100 (TOUT-IN). Then, the first load-lock-sided gate 501 is opened, and the transfer robot 101 transfers the second substrate to the load-lock chamber 500, then returns to the transfer chamber 100. Thereafter, the first load-lock-sided gate 501 is closed, The second substrate thusly deposited is discharged to an outside, and another substrate is positioned in the load-lock chamber 500 for subsequent processes in the second reaction chamber 320 (320-2, 3, ..., and n).

And, the deposition process on the third substrate in the third reaction chamber 33 is complete. Then, the third reaction chamber-sided gate 331 is opened, and the transfer robot 101 transfers the third substrate to the transfer chamber 100, then the third reaction chamber-sided gate 331 is closed (TOUT-IN). Under this circumstance, the transfer chamber-sided gate 103 is opened so that the transfer chamber 100 may communicate with the process-separation reaction chamber 200. Then, the transfer robot 101 transfers the third substrate to the process-separation reaction chamber 200 and then returns to the transfer chamber 100 and the transfer chamber-sided gate 103 is closed (TOUT-IN). Whereafter, a deposition process is performed in the process-separation reaction chamber 200.

When the process is complete in the process-separation reaction chamber 200, the transfer chamber-sided gate 103 is opened, and the transfer robot 101 transfers the third substrate to the transfer chamber 100 (TOUT-IN). Then, the first load-lock-sided gate 501 is opened, and the transfer robot 101 transfers the third substrate to the load-lock chamber 500, then returns to the transfer chamber 100. Thereafter, the first load-lock-sided gate 501 is closed. The third substrate thusly deposited is discharged to an outside, and subsequent processes (330-2, 3, .... and n) are performed on another substrate in in the third reaction chamber 330.

Fig. 16 is a view illustrating a MOCVD apparatus according to an embodiment of the present invention. Fig, 17 is a flowchart illustrating a MOCVD method according to an embodiment of the present invention.

Referring to Fig. 16, the MOCVD apparatus includes a transfer chamber 100(T1), which has a hexagonal shape, three reaction chambers 310, 320, and 330, a bluffer chamber 400(B), a load-lock chamber 500(L), and a process-separation reaction chamber 200(R2). The first reaction chamber 310, the second reaction chamber 320, and the third reaction chamber 33 form a buffer layer, an undoped GaN layer, an N-ype layer, and an active layer. The process-separation reaction chamber 200 forms a P-ype layer.

The buffer chamber 400 may be used to deposit a bluffer layer, an undoped GaN layer, an N-ype layer, an active layer, or a P-ype layer.

A load-lock-sided, gate 501 is provided between the load-lock chamber 500 and the transfer chamber 100.

A first reaction chamber-sided gate 311, a second reaction chamber-sided gate 321, and a third reaction chamber-sided gate 331, respectively, are provided between the transfer chamber 100 and the first reaction chamber 310, between the transfer chamber 100 and the second reaction chamber 320, and between the transfer chamber 100 and the third reaction chamber 330.

A transfer chamber-sided gate 103 is provided between the process-separation reaction chamber 200 and the transfer chamber 100, and a buffer chamber-sided gate 401 is provided between the transfer chamber 100 and the suffer chamber 400.

Substrates positioned in the load-lock chamber 500 are transferred to the first to third reaction chambers 310, 320, and 330, and the buffer chamber 400 by a transfer robot 101 provided in the transfer chamber 100 for depositing a buffer layer, an undoped GaN layer, an N-ype layer, and an active layer, Thereafter, when the processes are complete in the first to third reaction chambers 310, 320, and 330, and the buffer chamber 400, the substrates are transferred to the process-separation reaction chamber 200 by the transfer robot 101 for processes.

Assuming that the buffer chamber 400 is used to deposite a P-ype layer, the substrates are first subjected to processes in the first to third reaction chambers 310, 320, and 330, and then transferred to the buffer chamber 400 and the process-separation reaction chamber 200 by the transfer robot 101 for deposition of P-ype layers.

A MOCVD method according to an embodiment of the present invention will now be described, which includes procecces performed in the chambers.

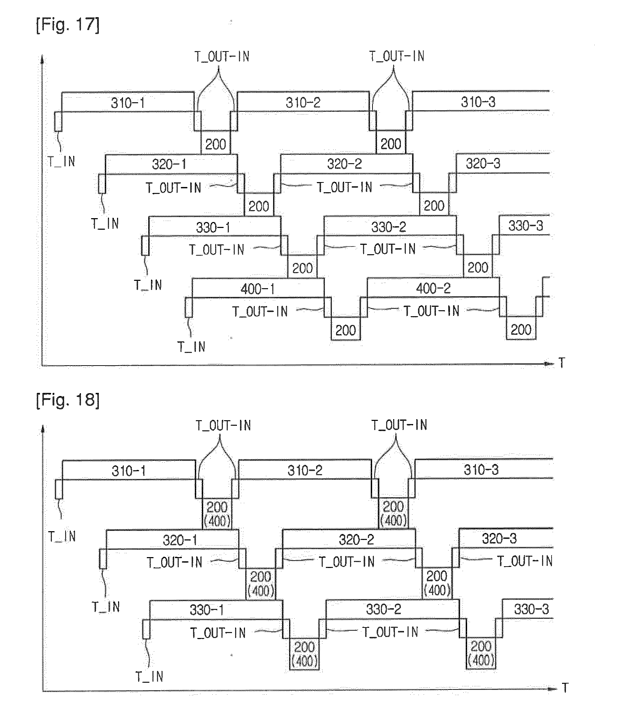

Fig. 17 illustrates an example of sequentially performing processes in the first reaction chamber 310 to the third reaction chamber 330 while the buffer chamber 400 is used for deposition similarly to the first to third reaction chambers 310, 320, and 330, wherein X axis refers to processing time and Y axis refers to transfer of the substrate 240 into each of the chambers. The processing conditions performed in the load-lock chamber 500, the transfer chamber 100, the reaction chambers 310, 320, and 330, and the bluffer chamber 400 and gases supplied into the chambers have been described above.

When a first substrate or a first susceptor on which a plurality of substrates are arranged is positioned in the load-lock chamber 500, the first load-lock-sided gate 501 is opened so that the transfer chamber 100 may communicate with the load-lock chamber 500. Under this circumstance, a transfer robot 101 of the transfer chamber 100 transfers the first substrate to the transfer chamber 100, and the first load-lock-sided gate 501 is closed (T-IN). Thereafter, the first reaction chamber-sided gate 31 is opened, and the transfer robot 101 transfers the first substrate to the first reaction chamber 310, then returns to the transfer chamber 100. Then, the first reaction chamber-sided gate 311 is closed. When processing conditions are satisfied, a deposition process is initiated (310-1).

When a second substrate or a second susceptor on which a plurality of substrates are arranged is positioned in the load-lock chamber 500, the first load-lock-sided gate 501 is opened so that the transfer chamber 100 may communicate with the load-lock chamber 500. Under this circumstance, the transfer robot 101 transfers the second substrate to the transfer chamber 100, and the first load-lock-sided gate 501 is closed (T-IN).

Hereafter, the second reaction chamber-sided gate 321 is opened, and the transfer robot 101 transfers the second substrate to the second reaction chamber 320, then returns to the transfer chamber 100. Then, the second reaction chamber-sided gate 321 is closed, When processing conditions are satisfied, a deposition process is initiated (320-1).

When a third substrate or a third susceptor on which a plurality of substrates are arranged is positioned in the load-lock chamber 500, the first load-lock-sided gate 501 is opened so that the transfer chamber 100 may communicate with the load-lock chamber 500. Under this circumstance, the transfer robot 101 transfers the third substrate to the transfer chamber 100, and the first load-lock-sided gate 501 is close (T-IN).

Thereafter, the third reaction chamber-sided gate 331 is opened, and the transfer robot 101 transfers the third substrate to the third reaction chamber 330, then returns to the transfer chamber 100. Then, the third reaction chamber-sided gate 331 is closed. When processing conditions are satisfied, a deposition process is initiated (330-1).

When a fourth substrate or a fourth susceptor on which a plurality of substrates are arranged is positioned in the load-lock chamber 500, the first load-lock-sided gate 501 is opened so that the transfer chamber 100 may communicate with the load-lock chamber 500. Under this circumstance, the transfer robot 101 transfers the fourth substrate to the transfer chamber 100, and the first load-lock-sided gate 501 is closed (T-IN).

Thereafter, the buffer chamber-sided gate 401 is opened, and the transfer robot 101 transfers the fourth substrate to the buffer chamber 400, then returns to the transfer chamber 100. Then, the buffer chamber-sided gate 401 is closed. When processing conditions are satisfied, a deposition process is initiated (400-1).

A predetermined time after the fourth substrate has been transferred to the buffer chamber 400, the deposition process on the first substrate in the first reaction chamber 310 is complete. Then, the first reaction chamber-sided gate 311 is opened, and the transfer robot 101 transfers the first substrate to the transfer chamber 100, then the first reaction chamber-sided gate 31 is closed (TOUT-IN). Under this circumstance, the transfer chamber-sided gate 103 is opened so that the transfer chamber 100 may communicate with the process-separation reaction chamber 200. Then, the transfer robot 101 transfers the first substrate to the process-separation reaction chamber 200, and then returns to the transfer chamber 100, then the transfer chamber-sided gate 103 is closed (TOUT-IN). Hereafter, a deposition process is initiated in the process-separation reaction chamber 200.

When the process is complete in the process-separation reaction chamber 200, the transfer chamber-sided gate 103 is opened, and the transfer robot 101 transfers the first substrate to the transfer chamber 100 (TOUT-IN), Then, the first load-lock-sided gate 501 is opened, and the transfer robot 101 transfers the first substrate to the load-lock chamber 500, then returns to the transfer chamber 100. Thereafter, the first load-lock-sided gate 501 is closed. The first substrate thusly deposited is discharged to an outside, and subsequent processes (310-2, 3, ..., and n) are performed on another substrate in the first reaction chamber 310.

And, the deposition process on the second substrate in the second reaction chamber 320 is complete. Then, the second reaction chamber-sided gate 321 is opened, and the transfer robot 101 transfers the second substrate to the transfer chamber 100, then the second reaction chamber-sided gate 321 is closed (TOUT-IN). Under this circumstance, the transfer chamber-sided gate 103 is opened so that the transfer chamber 100 may communicate with the process-separation reaction chamber 200. Then, the transfer robot 101 transfers the second substrate to the process-separation reaction chamber 200 and then returns to the transfer chamber 100 and the transfer chamber-sided gate 103 is closed (TOUT-IN). Thereafter, a deposition process is performed in the process-separation reaction chamber 200.

When the process is complete in the process-separation reaction chamber 200, the transfer chamber-sided gate 103 is opened, and the transfer robot 101 transfers the second substrate to the transfer chamber 100 (TOUT-IN). Then, the first load-lock-sided gate 501 is opened, and the transfer robot 101 transfers the second substrate to the load-lock chamber 500, then returns to the transfer chamber 100. Thereafter, the first load-lock-sided gate 501 is closed. The second substrate thusly deposited is discharged to an outside, and another substrate is positioned in the load-lock chamber 500 for subsequent processes in the second reaction chamber 320 (320-2, 3, ..., and n).

And, the deposition process on the third substrate in the third reaction chamber 330 is complete. Then, the third reaction chamber-sided gate 331 is opened, and the transfer robot 101 transfers the third substrate to the transfer chamber 100, then the third reaction chamber-sided gate 331 is close (TOUT-IN). Under this circumstance, the transfer chamber-sided gate 103 is opened so that the transfer chamber 100 may communicate with the process-separation reaction chamber 200. Then, the transfer robot 101 transfers the third substrate to the process-separation reaction chamber 200 and then returns to the transfer chamber 100 and the transfer chamber-sided gate 103 is closed (TOUT-IN). Thereafter, a deposition process is performed in the process-separation reaction chamber 200.

When the process is complete in the process-separation reaction chamber 200, the transfer chamber-sided gate 103 is opened, and the transfer robot 101 transfers the third substrate to the transfer chamber 100 (TOUT-IN). Then, the first load-lock-sided gate 501 is opened, and the transfer robot 101 transfers the third substrate to the load-lock chamber 500, then returns to the transfer chamber 100. Thereafter, the first load-lock-sided gate 501 is closed. The third substrate thusly deposited is discharged to an outside, and subsequent processes (330-2, 3, ..., and n) are performed on another substrate in in the third reaction chamber 330.

And, the deposition process on the fourth substrate in the buffer chamber 400 is complete. Then, the buffer chamber-sided gate 401 is opened, and the transfer robot 101 transfers the fourth substrate to the transfer chamber 100, then the buffer chamber-sided gate 401 is closed (TOUT-IN). Under this circumstance, the transfer chamber-sided gate 103 is opened so that the transfer chamber 100 may communicate with the process-separation reaction chamber 200. Then, the transfer robot 101 transfers the fourth substrate to the process-separation reaction chamber 200 and then returns to the transfer chamber 100 and the transfer chamber-sided gate 103 is closed (TOUT-IN). Thereafter, a deposition process is performed in the process-separation reaction chamber 200.

When the process is complete in the process-separation reaction chamber 200, the transfer chamber-sided gate 103 is opened, and the transfer robot 101 transfers the fourth substrate to the transfer chamber 100 (TOUT-IN). Then, the first load-lock-sided gate 501 is opened, and the transfer robot 101 transfers the fourth substrate to the load-lock chamber 500, then returns to the transfer chamber 100. Thereafter, the first load-lock-sided gate 501 is closed. The fourth substrate thusly deposited is discharged to an outside, and another substrate is positioned in the load-lock chamber 500 for subsequent processes in the buffer chamber 400 (400-2, 3, ..., and n).

Fig. 18 illustrates an example where processes are sequentially performed in the first to third reaction chambers 310, 320, and 330 and the buffer chamber 400 is used for deposition of a P-ype layer like the process-separation reaction chamber 200.

A predetermined time after the processes have been performed in the first to third reaction chambers 310, 320, and 330, the deposition process on the first substrate in the first reaction chamber 310 is complete. Then, the first reaction chamber-sided gate 311 is opened, and the transfer robot 101 transfers the first substrate to the transfer chamber 100, then the first reaction chamber-sided gate 311 is closed (TOUT-IN). Under this circumstance, the first substrate is transferred by the transfer robot 101 to the bluffer chamber 400 or the process-separation reaction chamber 200 for deposition of a P-ype layer. Assuming that the buffer chamber 400 is use for P-ype layer depositon of the first substrate, the buffer chamber-sided gate 401 is opened so that the the transfer chamber 100 may communicate with the buffer chamber 400. Then, the transfer robot 101 transfers the first substrate to the suffer chamber 400 and then returns to the transfer chamber 100. Then, the suffer chamber-sided gate 401 is closed (TOUT-IN). Thereafter, a deposition process is performed in the suffer chamber 400.

When the process is complete in the suffer chamber 400, the buffer chamber-sided gate 401 is opened, and the transfer robot 101 transfers the first substrate to the transfer chamber 100 (TOUT-IN). Then, the first load-lock-sided gate 501 is opened, and the transfer robot 101 transfers the first substrate to the load-lock chamber 500, then returns to the transfer chamber 100. Thereafter, the first load-lock-sided gate 501 is closed. The first substrate thusly deposited is discharged to an outside, and subsequent processes (310-2, 3, ..., and n) are performed on another substrate in the first reaction chamber 310.

And, the deposition process on the second substrate in the second reaction chamber 320 is complete. Then, the second reaction chamber-sided gate 321 is opened, and the transfer robot 101 transfers the second substrate to the transfer chamber 100, then the second reaction chamber-sided gate 321 is closed (TOUT-IN). Under this circumstance, a deposition process is performed by using one of the buffer chamber 400 and the process-separation reaction chamber 200. If the buffer chamber 400 is being used for a deposition process on the first substrate, the process-separation reaction chamber 200 may be use for a deposition process on the second substrate. However, if the deposition process on the first substrate in the buffer chamber 400 has been compete, the deposition process on the second substrate may be performed by using the buffer chamber 400.

If the deposition process on the first substrate is being performed in the buffer chamber 400, the transfer chamber-sided gate 103 is opened so that the transfer chamber 100 may communicate with the process-separation reaction chamber 200. Then, the transfer robot 101 transfers the second substrate to the process-separation reaction chamber 200 and then returns to the transfer chamber 100, then the transfer chamber-sided gate 103 is closed (TOUT-IN). Thereafter, a deposition process is performed in the process-separation reaction chamber 200.

When the process is complete in the process-separation reaction chamber 200, the transfer chamber-sided gate 103 is opened, and the transfer robot 101 transfers the second substrate to the transfer chamber 100 (TOUT-IN). Then, the first load-lock-sided gate 501 is opened, and the transfer robot 101 transfers the second substrate to the load-lock chamber 500, then returns to the transfer chamber 100. Then, the first load-lock-sided gate 501 is closed. The second substrate thusly deposited is discharged to an outside, and another substrate is positioned in the load-lock chamber 500 for subsequent processes (320-2, 3, ..., and n) in the third reaction chamber 330.

Also when the deposition process on the third substrate is complete in the third reaction chamber 330, it is checked whether the buffer chamber 400 and the process-separation reaction chamber 200 are in the middle of operation as described above. For example, after deposition in the third reaction chamber 330, one of the process-separation reaction chamber 200 and the buffer chamber 400 is selected for deposition of a P-ype layer on the third substate. If a deposition process is being performed in the buffer chamber 400, a process on the third substrate may be performed in the process-separation reaction chamber 200, and if a deposition process is being performed in the process-separation reaction chamber 200, a process on the third substrate may be performed in the suffer chamber 400. Then, the third substrate thusly deposited is discharged to an outside, and then subsequent processes (330-2, 3, ..., and n) are performed.

The MOCVD apparatus and method according to the embodiments of the present invention may repeatedly perform the same process in each chamber a few tens of times or more without a maintenance process, such as washing inside the chambers. The transfer of substrates or susceptors between the chambers is performed by the transfer robot, thus enhancing efficiency of epitaxial processes in high temperature environments. Chambers for formation of the buffer layer, undoped layer, and n-ype layer, a chamber for formation of the active layer, and a chamber for formation of the p-ype layer may be independently configured from one another.

Although the exemplary embodiments of the invention have been described, it is understood that the present invention should not be limited to these exemplary embodiments but various changes and modifications can be made by one ordinary skilled in the art within the spirit and scope of the present invention as hereinafter claimed.

## Claims

1. layer deposition apparatus comprising:
a load-lock chamber in which a substrate is loaded;
a transfer chamber having a transfer robot that transfers the substrate;
a reaction chamber that receives the substrate from the transfer robot and grows at least one epitaxial layer on the substrate;
a process-separation reaction chamber that receives the substrate and forms at least one epitaxial layer on the substrate; and
a gas distributor that supplies a processing gas to the reaction chamber and the process-separation reaction chamber.

2. The layer deposition apparatus of claim 1, wherein the reaction chamber epitaxially grows an n-type layer and an active layer on the substrate.

3. The layer deposition apparatus of claim 1, wherein the process-separation reaction chamber epitaxially grows a p-type layer on the active layer.

4. The layer deposition apparatus of claim 1, further comprising one or more reaction chamber, each reaction chamber receiving a substrate from the transfer robot and growing at least one epitaxial layer on the substrate, wherein the transfer robot sequentially transfers substrates from the plurality of reaction chambers to the process-separation reaction chamber.

5. layer deposition method comprising:
loading a substrate positioned in a load-lock chamber into a transfer chamber by a transfer robot provided in the transfer chamber;
transferring the substrate to a reaction chamber;
forming at least one epitaxial layer on the substrate in the reaction chamber;
transferring the substrate from the reaction chamber to a process-separation reaction chamber by the transfer robot;
supplying a second substrate to the reaction chamber and forming at least one epitaxial layer on the second substrate in the reaction chamber;
forming at least one epitaxial layer on the substrate in the process-separation reaction chamber;
transferring the substrate from the process-separation reaction chamber to the load-lock chamber by the transfer robot; and
transferring the second substrate to the process-separation reaction chamber.

6. The layer deposition method of claim 5, wherein the reaction chamber epitaxially grows an n-type layer and an active layer on the substrate.

7. The layer deposition method of claim 6, wherein the process-separation reaction chamber epitaxially grows a p-type layer on the active layer.

8. The layer deposition method of claim 5, wherein one or more reaction chamber is connected to the transfer chamber, wherein each reaction chamber receives a substrate from the transfer robot and grows at least one epitaxial layer on the substrate, wherein the transfer robot sequentially transfers substrates from the plurality of reaction chambers to the process-separation reaction chamber.
